(19) Europäisches Patentamt
European Patent Office
Office européen des brevets

(11) **EP 4 087 124 A1**

(12) **EUROPEAN PATENT APPLICATION**
published in accordance with Art. 153(4) EPC

(43) Date of publication:
**09.11.2022 Bulletin 2022/45**

(51) International Patent Classification (IPC):
***H03F 3/20*** (2006.01)

(21) Application number: **20910533.7**

(86) International application number:
**PCT/CN2020/139580**

(22) Date of filing: **25.12.2020**

(87) International publication number:
**WO 2021/136103 (08.07.2021 Gazette 2021/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.12.2019 CN 201911413677**

(71) Applicant: **Comba Network Systems Company Limited**
**Guangzhou, Guangdong 510663 (CN)**

(72) Inventors:
• **CHEN, Taimeng**
 **Guangzhou, Guangdong 510663 (CN)**
• **FAN, Qiyan**
 **Guangzhou, Guangdong 510663 (CN)**
• **LIU, Haitao**
 **Guangzhou, Guangdong 510663 (CN)**

(74) Representative: **J A Kemp LLP**
**80 Turnmill Street**
**London EC1M 5QU (GB)**

(54) **POWER AMPLIFIER**

(57) A power amplifier comprising a first PCB, a second PCB, a power amplification tube circuit, and a circulator, wherein the power amplification tube circuit is connected to a first end of the circulator by means of a first microstrip line, a second end of the circulator is connected to a second microstrip line, the first microstrip line and the power amplification tube circuit are arranged on the first PCB, the second microstrip line is arranged on the second PCB, and the circulator is arranged on the first PCB or the second PCB. By designing the first PCB and the second PCB, arranging the first microstrip line arranged on the first PCB, and arranging the second microstrip line arranged on the second PCB, only the second PCB of an output end needs to be replaced when a microstrip line of the output end is burnt; and in addition, the power capacity of the microstrip line can be improved by designing microstrip lines with different characteristic impedances.

FIG. 1

**Description**

**TECHNICAL FIELD**

The present invention relates to the field of radio frequency amplification technologies, and in particular, to a power amplifier.

**BACKGROUND**

A power amplifier is widely used in systems such as microwave heating, wireless communication, satellite communication, and radar. The power amplifier has functions of amplifying a microwave signal and feeding the microwave signal to an apparatus containing a body to be heated or transmitting the microwave signal to space through an antenna. Due to long-time operation at high temperatures and high power, the power amplifier is more likely to malfunction and fail than other hardware of the system. Therefore, the system has a high requirement for reliability of the power amplifier. The most burnable part of the power amplifier is an output end thereof. In particular, when the power amplifier has output power above 100 W or even 1000 W, the disadvantage is particularly obvious. In addition to ensuring the reliability of the power amplifier, a power conduction manner is more important. A PCB is a physical transmission carrier. Power capacity and transmission loss of a transmission line and thermal conductivity of the transmission carrier are key considerations.

Key parameters of the PCB include $\tan\delta$, a thermal conductivity coefficient $coe_{tc}$, and a dielectric constant $\varepsilon_r$. The larger the loss factor $\tan\delta$, the larger the power transmission loss. The larger the thermal conductivity coefficient $coe_{tc}$, the more conducive to heat dissipation. The value of the dielectric constant $\varepsilon_r$ determines a width of a microstrip transmission line and plays a decisive role in the power capacity of the microstrip transmission line. The wider the microstrip line, the greater the power capacity.

The related art has the following drawback. The power amplifier is only suitable for output of small and medium power, but it is difficult or impossible to guarantee reliable output of 100 W and 1000 W grades. Besides, a high power amplifier such as a 1000 W-grade device is generally synthesized by a plurality of modules through an external combiner, which has disadvantages such as a complex structure, high costs, great loss, and a large volume.

**SUMMARY**

The present invention is intended to provide a power amplifier to overcome at least one drawback (deficiency) of the related art, which helps improve the power capacity of the microstrip line and facilitates replacement of a PCB at an output end when a microstrip line at the output end is burnt.

The present invention adopts the following technical solution.

A power amplifier is provided, including a first PCB, a second PCB, a power amplification tube circuit, and a circulator.

The power amplification tube circuit is connected to a first terminal of the circulator by means of a first microstrip line, a second terminal of the circulator is connected to a second microstrip line, the first microstrip line and the power amplification tube circuit are arranged on the first PCB, the second microstrip line is arranged on the second PCB, and the circulator is arranged on the first PCB or the second PCB.

By designing the first PCB and the second PCB, arranging the first microstrip line on the first PCB, and arranging the second microstrip line on the second PCB, only the second PCB at an output end needs to be replaced when a microstrip line at the output end is burnt. In addition, the power capacity of the microstrip line can be improved by designing microstrip lines with different characteristic impedances.

Further, a designed characteristic impedance of the first microstrip line is less than or equal to a designed characteristic impedance of the second microstrip line.

By designing the characteristic impedance of the first microstrip line to be less than or equal to that of the second microstrip line, the first microstrip line and the second microstrip line can have greater power capacity, so as to improve reliability of the power amplifier.

Further, a dielectric constant $\varepsilon_{r1}$ of the first PCB is greater than or equal to a dielectric constant $\varepsilon_{r2}$ of the second PCB.

A dielectric thickness $d_1$ of the first PCB is less than a dielectric thickness $d_2$ of the second PCB when the dielectric constant $\varepsilon_{r1}$ of the first PCB is equal to the dielectric constant $\varepsilon_{r2}$ of the second PCB.

By correlating the dielectric constant $\varepsilon_{r1}$ and the dielectric thickness $d_1$ of the first PCB with the dielectric constant $\varepsilon_{r2}$ and the dielectric thickness $d_2$ of the second PCB 3, the overall loss of the power amplifier can be reduced.

Further, a third terminal of the circulator is further connected to a third microstrip line arranged on the first PCB or the second PCB.

By connecting the third microstrip line to the third terminal of the circulator, the third microstrip line can accommodate the power of the power amplifier during total reflection, so that the third terminal of the circulator can better determine a standing wave condition of the power amplifier at an output port.

Further, a designed characteristic impedance of the third microstrip line is equal to a designed characteristic impedance of the second microstrip line.

By designing the characteristic impedance of the third microstrip line to be equal to that of the second microstrip line, the third microstrip line can fully accommodate the power of the power amplifier during total reflection.

Further, the power amplification tube circuit includes multiple stages of power amplification tubes arranged on the first PCB, the multiple stages of power amplification tubes being successively cascaded by means of fourth microstrip lines, and the power amplification tube cascaded at the end being connected to the first terminal of the circulator by means of the first microstrip line.

By arranging a plurality of power amplification tubes on the first PCB and successively cascading the plurality of power amplification tubes by means of the fourth microstrip lines, multi-stage power amplification is performed on the microwave signal to enable the power amplifier to achieve high power output. Further, the power amplification tube circuit includes a power divider, multiple stages of power amplification tubes, and a power combiner. The power divider, the multiple stages of power amplification tubes, and the power combiner are arranged on the first PCB. The multiple stages of power amplification tubes are successively cascaded by means of fourth microstrip lines. At least two power amplification tubes are cascaded at the end, input terminals of at least two last-stage power amplification tubes are respectively connected to a fourth microstrip line following the power amplifier tube of a previous stage by means of the power divider, output terminals of the at least two last-stage power amplification tubes are respectively connected to the power combiner, and the power combiner is connected to the first terminal of the circulator by means of the first microstrip line.

By connecting the power divider and the at least two last-stage power amplification tubes, the received microwave signal can be divided into several channels for power amplification, and the power combiner integrates and outputs microwave signals that pass through different power amplifiers to reduce the loss of the microwave signals.

Further, a plurality of circulators are provided. Second terminals of the plurality of circulators are connected to the second microstrip line by means of a power combiner, and the power combiner is arranged on the second PCB.

The power amplification tube circuit includes a power divider and multiple stages of power amplification tubes. The power divider and the multiple stages of power amplification tubes are arranged on the first PCB. The multiple stages of power amplification tubes are successively cascaded by means of fourth microstrip lines. A plurality of power amplification tubes are cascaded at the end and the same as the circulators in number. Input terminals of the plurality of last-stage power amplification tubes are respectively connected to the fourth microstrip line following the power amplifier tube of a previous stage by means of the power divider. Output terminals of the plurality of last-stage power amplification tubes are respectively connected to first terminals of the corresponding circulators by means of the first microstrip line.

By connecting the plurality of circulators to the plurality of last-stage power amplification tubes in a one-to-one correspondence manner, the output terminals of the plurality of last-stage power amplification tubes and the load do not interfere with each other and are independent of each other.

Further, the first terminal of the circulator is soldered on the first microstrip line, and the second terminal of the circulator is soldered on the second microstrip line.

By soldering the first terminal of the circulator on the first microstrip line and soldering the second terminal of the circulator on the second microstrip line, a small-sized circulator can be fixed between the first microstrip line and the second microstrip line.

Further, the power amplifier further includes a radio frequency adapter, the second terminal of the circulator being connected to the radio frequency adapter by means of the second microstrip line.

By soldering a radio frequency adapter on the second microstrip line, the radio frequency adapter can be used as an output port of the entire power amplifier.

Compared with the related art, the present invention has the following beneficial effects. By designing a power amplifier including a plurality of PCBs and a plurality of microstrip lines for transmission, only the PCB at an output end needs to be replaced when a microstrip line at the output end is burnt. By designing microstrip lines with different characteristic impedances, the power capacity of the microstrip line is improved, insertion loss and a heating quantity of the microstrip line are reduced, and the difficulty of electric breakdown and thermal breakdown is increased by increasing an envelope-ground spacing of the microstrip line, so as to greatly improve the reliability of the power amplifier in the present invention. The present invention is featured with a simple structure, low costs, and high practical application value.

**BRIEF DESCRIPTION OF THE DRAWINGS**

FIG. 1 is a schematic diagram illustrating a configuration of a power amplifier according to Embodiment One of the present invention.
FIG. 2 is a schematic diagram illustrating a configuration of a power amplifier according to Embodiment Two of the present invention.
FIG. 3 is a schematic diagram illustrating a part of a power amplifier according to Embodiment Three of the present invention.
FIG. 4 is a schematic diagram illustrating a part of a power amplifier according to Embodiment Four of the present invention.

**DETAILED DESCRIPTION OF THE EMBODIMENTS**

The drawings of the present invention are only for illustrative purposes and cannot be interpreted as limitations on the present invention. In order to better describe the following embodiment, some components in the drawings may be omitted, enlarged or reduced, which do not represent actual product sizes. It may be understood by those skilled in the art that some well-known structures and descriptions thereof may be omitted in the drawings.

**Embodiment One**

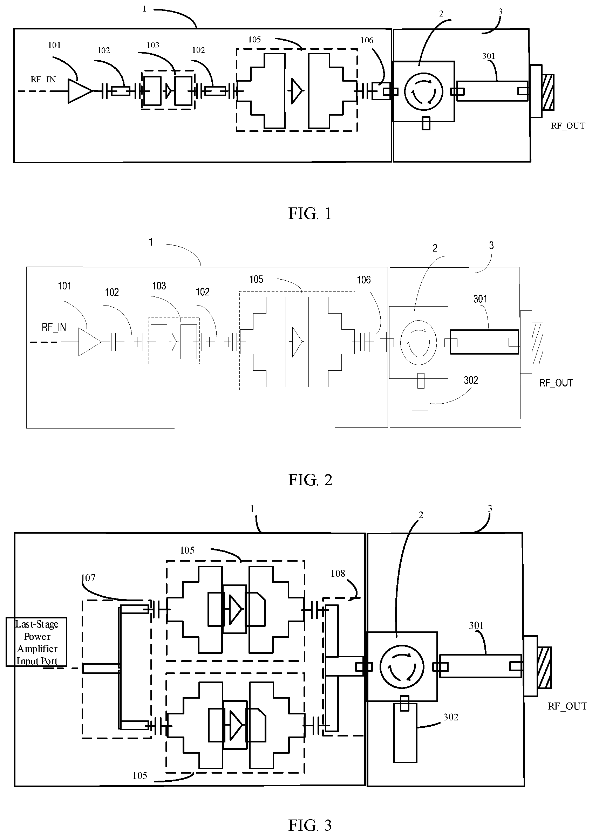

FIG. 1 is a schematic diagram illustrating a configuration of a power amplifier according to Embodiment One of the present invention. Referring to FIG. 1, the power amplifier includes a first PCB 1, a second PCB 3, a power amplification tube circuit, and a circulator 2.

The power amplification tube circuit is connected to a first terminal of the circulator 2 by means of a first microstrip line 106, a second terminal of the circulator 2 is connected to a second microstrip line 301, the first microstrip line 106 and the power amplification tube circuit are arranged on the first PCB 1, the second microstrip line 301 is arranged on the second PCB 3, and the circulator is arranged on the first PCB 1 or the second PCB 3 (as shown in FIG. 1).

During specific implementation, the power amplification tube circuit is connected to a first terminal of the circulator 2 by means of a first microstrip line 102. A microwave signal is input from RF_IN, amplified by the power amplification tube circuit, output to the circulator 2 by means of the first microstrip line 106, and output to the second PCB 3 by the second microstrip line 301 connected to the circulator 2. The signal is output by the second PCB 3. The second microstrip line 301 is arranged on the second PCB 3. The circulator 2 may be arranged on the second PCB 3. During specific implementation, the circulator 2 may also be arranged on the first PCB 1.

As a example, when a characteristic impedance of the first microstrip line 106 is designed to be 25 Ω and a characteristic impedance of the second microstrip line 301 is designed to be 50 Ω, according to a formula

$$Z = \sqrt{L/C}$$

, $C = \varepsilon_r * S / d$, where Z denotes the characteristic impedance of the microstrip line, L denotes an inductive reactance of the microstrip line, C denotes a capacitive reactance of the microstrip line, $\varepsilon_r$ denotes a dielectric constant of the PCB, s denotes an area of the microstrip line, and d denotes a dielectric thickness of the PCB, it may be calculated that the second microstrip line 301 with the characteristic impedance of 50 Ω arranged on the second PCB 3 has a larger physical size and can accommodate higher transmission power, and ideal matching can be achieved due to the characteristic impedance of 50 Ω. In addition, an envelope-ground spacing of the second microstrip line 301 with the characteristic impedance of 50 Ω should be appropriately increased to increase the difficulty of air breakdown between the microstrip line and the ground.

By designing the first PCB 1 and the second PCB 2, arranging the first microstrip line 106 on the first PCB 1, and arranging the second microstrip line 301 on the second PCB 3, only the second PCB at an output end needs to be replaced when a microstrip line at the output end is burnt. In addition, the power capacity of the microstrip line can be improved by designing microstrip lines with different characteristic impedances.

In an optional embodiment, a designed characteristic impedance of the first microstrip line 106 is less than or equal to that of the second microstrip line 301.

Specifically, after a signal passes through the power amplification tube circuit, the first microstrip line 106 needs to carry high power. The characteristic impedance of the first microstrip line 106 is designed to be 25 Ω to increase a physical size and power capacity of the first microstrip line 106. When a dielectric constant $\varepsilon_{r1}$ of the first PCB 1 is greater than or equal to a dielectric constant $\varepsilon_{r2}$ of the second PCB 3, the characteristic impedance of the second microstrip line 301 is designed to be greater than that of the first microstrip line 106, so that the second microstrip line 301 can accommodate higher transmission power. Ideal matching can be achieved when the characteristic impedance of the second microstrip line 301 is designed to be 50 Ω, so that the power capacity of the microstrip line is optimal. When the dielectric constant $\varepsilon_{r1}$ of the first PCB 1 is equal to the dielectric constant $\varepsilon_{r2}$ of the second PCB 3, the characteristic impedance of the second microstrip line 301 is designed to be equal to that of the first microstrip line 106, so that the second microstrip line 301 can accommodate higher transmission power.

By designing the characteristic impedance of the first microstrip line 106 to be less than or equal to that of the second microstrip line 301, the first microstrip line 106 and the second microstrip line 301 can have greater power capacity, so as to improve reliability of the power amplifier.

In an optional embodiment, a dielectric constant $\varepsilon_{r1}$ of the first PCB 1 is greater than or equal to a dielectric constant $\varepsilon_{r2}$ of the second PCB 3.

A dielectric thickness $d_1$ of the first PCB 1 is less than a dielectric thickness $d_2$ of the second PCB 3 when the dielectric constant $\varepsilon_{r1}$ of the first PCB 1 is equal to the dielectric constant $\varepsilon_{r2}$ of the second PCB 3.

Specifically, the dielectric constant $\varepsilon_{r1}$ of the first PCB 1 may be greater than the dielectric constant $\varepsilon_{r2}$ of the second PCB 3, and the dielectric constant $\varepsilon_{r1}$ of the first PCB 1 may also be equal to the dielectric constant $\varepsilon_{r2}$ of the second PCB 3. The dielectric constant $\varepsilon_{r1}$ of the first PCB 1 is designed to be greater than the dielectric constant $\varepsilon_{r2}$ of the second PCB 3, so that the characteristic impedance of the first microstrip line 106 is less than that of the second microstrip line 301. The dielectric thickness $d_1$ of the first PCB 1 is less than the dielectric thickness $d_2$ of the second PCB 3 when the dielectric constant

$\varepsilon_{r1}$ of the first PCB 1 is equal to the dielectric constant $\varepsilon_{r2}$ of the second PCB 3, so that an insertion loss value of the signal on the first PCB 1 is reduced and the second PCB 3 can receive a more accurate microwave signal.

By correlating the dielectric constant $\varepsilon_{r1}$ and the dielectric thickness $d_1$ of the first PCB 1 with the dielectric constant $\varepsilon_{r2}$ and the dielectric thickness $d_2$ of the second PCB 3, the overall loss value of the power amplifier can be reduced.

In an optional implementation, since a loss factor $\tan\delta$ of the PCB directly affects the power transmission loss of the PCB and a thermal conductivity coefficient $coe_{tc}$ of the PCB directly affects heat dissipation performance of the PCB, according to a power conduction manner between the first PCB 1 and the second PCB 3, during specific implementation of the power amplifier in this embodiment, the loss factor $\tan\delta$ of the second PCB 3 may be equal to or less than the loss factor $\tan\delta$ of the first PCB 1. In this way, the power transmission loss in the second PCB 3 may be equal to or less than the power transmission loss in the first PCB board 1, which can improve power capacity of a transmission line at an output end of a high power amplifier. Similarly, the thermal conductivity coefficient $coe_{tc}$ of the second PCB 3 may be greater than or equal to the thermal conductivity coefficient $coe_{tc}$ of the first PCB 1. In this way, heat dissipation performance in the second PCB 3 may be equivalent to or better than heat dissipation performance in the first PCB 1, so that the output end of the high power amplifier with high heat consumption has better heat dissipation performance, thereby improving the reliability of the high power amplifier.

In an optional embodiment, as shown in FIG. 1, the power amplification tube circuit includes multiple stages of power amplification tubes, the multiple stages of power amplification tubes is arranged on the first PCB 1, the multiple stages of power amplification tubes are successively cascaded by means of fourth microstrip lines 102, and the power amplification tube cascaded at the end is connected to the first terminal of the circulator 2 by means of the first microstrip line 106. In a preferred implementation, all stages of power amplification tubes and microstrip lines correspondingly connected thereto are DC blocked by capacitors to achieve isolation between devices.

In an application example, as shown in FIG. 1, the power amplification tube circuit includes an amplification tube 101, a drive-stage power amplifier tube 103, and a last-stage power amplifier tube 105. A microwave signal is input from RF IN, pre-amplified by the amplification tube 101, DC blocked by a capacitor, and transmitted to the drive-stage power amplifier tube 103 through the first fourth microstrip line 102 and a DC blocking capacitor. The drive-stage power amplifier tube 103 transmits the amplified signal to the last-stage power amplifier tube 105 through the second fourth microstrip line 102 and DC blocking capacitors positioned on two ends of the fourth microstrip line 102. Output of the last-stage power amplifier tube 105 is connected to the first microstrip line 106 through a DC blocking capacitor. Based on the application example, the characteristic impedance of the first microstrip line 106 may be designed to be 25 Ω, and the characteristic impedances of the two fourth microstrip lines 102 may be designed to be 50 Ω. By designing the characteristic impedance of the first microstrip line 106 to be less than that of the fourth microstrip line 102, the first microstrip line 106 may be of a relatively large size, so as to improve the power capacity thereof.

By arranging a plurality of power amplification tubes on the first PCB 1 and successively cascading the plurality of power amplification tubes by means of the fourth microstrip lines 102, multi-stage power amplification is performed on the microwave signal to enable the power amplifier to achieve high power output.

In another implementation, the first terminal of the circulator 2 is soldered on the first microstrip line 106, and the second terminal of the circulator 2 is soldered on the second microstrip line 301.

Specifically, by soldering the first terminal of the circulator 2 on the first microstrip line 106 and soldering the second terminal of the circulator 2 on the second microstrip line 301, a small-sized circulator 2 can be fixed between the first microstrip line 106 and the second microstrip line 301.

In another implementation, the power amplifier further includes a radio frequency adapter, and the second terminal of the circulator 2 is connected to the radio frequency adapter by means of the second microstrip line 301. During specific implementation, the radio frequency adapter may be mounted to the second PCB 3 by direct soldering.

Specifically, the power amplifier includes a first PCB 1, a circulator 2, a second PCB 3, and a radio frequency adapter. The radio frequency adapter is soldered on the second microstrip line 301 and is connected to the circulator 2 by means of the second microstrip line 301. The radio frequency adapter may be selected according to power capacity. If the power capacity ranges from 100 W to 300 W, an N-type adapter may be selected. If the power capacity is 300 W or more, a T-type adapter with a larger physical size may be selected.

By soldering a radio frequency adapter on the second microstrip line 301, the radio frequency adapter can be used as an output port of the entire power amplifier.

In Embodiment One, by designing a power amplifier including a plurality of PCBs and a plurality of microstrip lines for transmission, only the PCB at the output end needs to be replaced when a microstrip line at the output end is burnt. By designing microstrip lines with different characteristic impedances, the power capacity of the microstrip line is improved, and insertion loss and a heating quantity of the microstrip line are reduced. So, a power amplifier with high power can be realized.

## Embodiment Two

As shown in FIG. 2, Embodiment Two of the present invention provides a power amplifier in another configuration, which is different from Embodiment One in that a third terminal of the circulator 2 is further connected to a third microstrip line 302 and the third microstrip line 302 is arranged on the first PCB 1 or the second PCB 3 (as shown in FIG. 2).

During specific implementation, as shown in FIG. 2, the third microstrip line 302 is arranged on the second PCB 3, so that the third microstrip line 302 can accommodate power of total reflection when the total reflection occurs in the power amplifier, and the third terminal of the circulator 2 can better determine a standing wave condition of the power amplifier at an output port.

By connecting the third microstrip line 302 to the third terminal of the circulator 2, the third microstrip line 302 can accommodate the power of the power amplifier during total reflection, so that a third port of the circulator 2 can better determine a standing wave condition of the power amplifier at an output port.

In an optional embodiment, a designed characteristic impedance of the third microstrip line 302 is equal to that of the second microstrip line 301.

Specifically, when total reflection occurs in the power amplifier, the third microstrip line 302 needs to accommodate as much power as the second microstrip line 301 outputs. The characteristic impedance of the third microstrip line 302 is designed to be equal to that of the second microstrip line 301, such as 50 $\Omega$, so that the third microstrip line 302 can fully accommodate the power of the power amplifier during total reflection.

By designing the characteristic impedance of the third microstrip line 302 to be equal to that of the second microstrip line 301, the third microstrip line 302 can fully accommodate the power of the power amplifier during total reflection.

## Embodiment Three

Different from Embodiment One, in this embodiment, the power amplification tube circuit of the power amplifier is realized with another configuration. Specifically, the power amplification tube circuit includes a power divider 107, multiple stages of power amplification tubes, and a power combiner 108. The power divider 107, the multiple stages of power amplification tubes, and the power combiner 108 are arranged on the first PCB. The multiple stages of power amplification tubes are successively cascaded by means of fourth microstrip lines 102. At least two power amplification tubes are cascaded at the end. Input terminals of at least two last-stage power amplification tubes 105 are respectively connected to the fourth microstrip line 102 following the power amplifier tube of a previous stage by means of the power divider 107. Output terminals of the at least two last-stage power amplification tubes 105 are respectively connected to the power combiner 108. The power combiner 108 is connected to the first terminal of the circulator 2 by means of the first microstrip line 106.

In an optional implementation, like the device isolation principle in Embodiment One, the at least two last-stage power amplifiers may be connected to the power divider 107 and the power combiner 108 through a DC blocking capacitor, so as to achieve isolation between devices.

Referring to FIG. 1 or FIG. 2 together, FIG. 3 is a schematic diagram illustrating an application example of another power amplifier according to Embodiment Two of the present invention.

As shown in FIG. 1 or FIG. 2, a microwave signal is input from RF IN, pre-amplified by the amplification tube 101, DC blocked by a capacitor, and is transmitted to the drive-stage power amplifier tube 103 through the first fourth microstrip line 102 and a DC blocking capacitor. The drive-stage power amplifier tube 103 transmits the amplified signal to the last-stage power amplifier tube 105 through the second fourth microstrip line 102 and DC blocking capacitors positioned on two ends of the fourth microstrip line 102. Different from Embodiment One and Embodiment Two, in this embodiment, as shown in FIG. 3, two last-stage power amplifier tubes 105 are provided. Input terminals of the two last-stage power amplifier tubes 105 are respectively connected to the power divider 107 through DC blocking capacitors. The power divider 107 is connected to the second fourth microstrip line 102. Output terminals of the two last-stage power amplifier tubes 105 are respectively connected to the power combiner 108 through the DC blocking capacitors. The power combiner 108 is connected to the first terminal of the circulator 2. The power combiner 108 is connected to the first terminal of the circulator 2 by means of the first microstrip line 106. The second terminal of the circulator 2 is connected to the second microstrip line 301. The multiple stages of power amplification tubes, the fourth microstrip line 102, the power divider 107, the power combiner 108, and the first microstrip line 106 are all arranged on the first PCB 1, the second microstrip line 301 is arranged on the second PCB 3, and the circulator 2 is arranged on the first PCB 1 or the second PCB 3 (as shown in FIG. 3).

Different from Embodiment One, in Embodiment Three, by connecting the power divider 107 and the at least two last-stage power amplification tubes 105, the microwave signal received by the last-stage power amplification tubes can be divided into several channels for power amplification, and the power combiner 108 integrates and outputs microwave signals that pass through different power amplifiers to reduce the loss of the microwave signals.

In an optional implementation, Embodiment Three may be combined with the solution in Embodiment Two. As shown in FIG. 3, a third terminal of the circulator 2 is further connected to a third microstrip line 302, and the third microstrip line 302 is arranged on the first PCB 1 or the second PCB 3 (as shown in FIG. 2).

During specific implementation, as shown in FIG. 3, the third microstrip line 302 is arranged on the second PCB 3, so that the third microstrip line 302 can accommodate power of total reflection when the total reflection occurs in the power amplifier, and a third port of the circulator 2 can better determine a standing wave condition of the power amplifier at an output port.

By connecting the third microstrip line 302 to the third terminal of the circulator 2, the third microstrip line 302 can accommodate the power of the power amplifier during total reflection, so that a third port of the circulator 2 can better determine a standing wave condition of the power amplifier at an output port.

Further, a designed characteristic impedance of the third microstrip line 302 is equal to that of the second microstrip line 301.

Specifically, when total reflection occurs in the power amplifier, the third microstrip line 302 needs to accommodate as much power as the second microstrip line 301 outputs. The characteristic impedance of the third microstrip line 302 is designed to be equal to that of the second microstrip line 302, such as 50 Ω, so that the third microstrip line 302 can fully accommodate the power of the power amplifier during total reflection.

By designing the characteristic impedance of the third microstrip line 302 to be equal to that of the second microstrip line 301, the third microstrip line 302 can fully accommodate the power of the power amplifier during total reflection.

**Embodiment Four**

Different from Embodiment One, in Embodiment Four, a power amplification tube circuit and a circulator 2 of a power amplifier are realized with another configuration. Specifically, a plurality of circulators 2 are provided, second terminals of the plurality of circulators 2 are connected to the second microstrip line 301 by means of a power combiner 108, and the power combiner 108 is arranged on the second PCB 3. The power amplification tube circuit includes a power divider 107 and multiple stages of power amplification tubes. The power divider 107 and the multiple stages of power amplification tubes are arranged on the first PCB 1. The multiple stages of power amplification tubes are successively cascaded by means of fourth microstrip lines 102. A plurality of power amplification tubes are cascaded at the end and the same as the circulators 2 in number. Input terminals of the plurality of last-stage power amplification tubes are respectively connected to the fourth microstrip line 102 following the power amplifier tube of a previous stage by means of the power divider 107, and output terminals of the plurality of last-stage power amplification tubes are respectively connected to first terminals of the corresponding circulators 2 by means of the first microstrip line 106.

In an optional implementation, like the device isolation principle in Embodiment One, the at least two last-stage power amplifiers may be connected to the power divider 107 and the first microstrip line 106 through a DC blocking capacitor, so as to achieve isolation between devices.

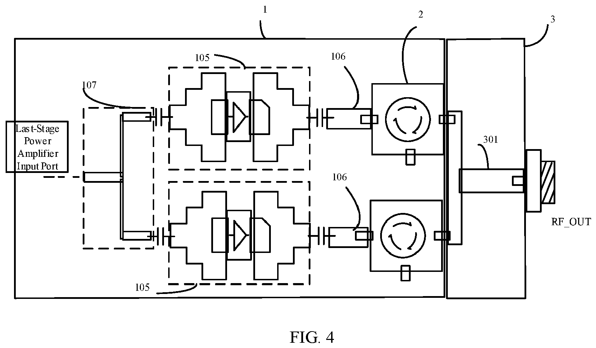

Referring to FIG. 1 together, FIG. 4 is a schematic diagram illustrating an application example of another power amplifier according to Embodiment Four of the present invention.

As shown in FIG. 1 or FIG. 2, a microwave signal is input from RF_IN, pre-amplified by the amplification tube 101, DC blocked by a capacitor, and is transmitted to the drive-stage power amplifier tube 103 through the first fourth microstrip line 102 and a DC blocking capacitor. The drive-stage power amplifier tube 103 transmits the amplified signal to the last-stage power amplifier tube 105 through the second fourth microstrip line 102 and DC blocking capacitors positioned on two ends of the fourth microstrip line 102. Different from Embodiment One, in this embodiment, as shown in FIG. 4, two last-stage power amplifier tubes 105 are provided. Input terminals of the two last-stage power amplifier tubes 105 are respectively connected to the power divider 107 through DC blocking capacitors. The power divider 107 is connected to the second fourth microstrip line 102. Output terminals of the two last-stage power amplifier tubes 105 are each connected to a first terminal of one circulator 2 by means of the first microstrip line 106 after passing through the DC blocking capacitors. Second terminals of two circulators 2 are connected to the power combiner 108. The power combiner 108 is connected to the second microstrip line 301. The multiple stages of power amplification tubes, the fourth microstrip line 102, the power divider 107, the first microstrip line 106, and the two circulators 2 are all arranged on the first PCB 1, and the second microstrip line 301 and the power combiner 108 are arranged on the second PCB 3.

Different from Embodiment One, in Embodiment Four, by connecting the power divider 107 and the at least two last-stage power amplification tubes 105, the received microwave signal can be divided into several channels for power amplification, and the power combiner 108 integrates and outputs microwave signals that pass through different power amplifiers to reduce the loss of the microwave signals. Further, in Embodiment Four, by connecting the plurality of circulators to the plurality of last-stage power amplification tubes in a one-to-one correspondence manner, the output terminals of the plurality of last-stage power amplification tubes and the load do not interfere with each other and are independent of each other.

Obviously, the above embodiments of the present invention are examples merely provided for clearly illustrating the technical solutions of the present invention, and not intended to limit specific implementations of the present invention. Any modification, equivalent replacement, improvement and the like made within the spirit and principle of the claims of the present invention should fall within the protection scope of the claims of the present invention.

## Claims

1. A power amplifier, comprising a first PCB, a second PCB, a power amplification tube circuit, and a circulator,
wherein the power amplification tube circuit is connected to a first terminal of the circulator by means of a first microstrip line, a second terminal of the circulator is connected to a second microstrip line, the first microstrip line and the power amplification tube circuit are arranged on the first PCB, the second microstrip line is arranged on the second PCB, and the circulator is arranged on the first PCB or the second PCB.

2. The power amplifier of claim 1, wherein a designed characteristic impedance of the first microstrip line is less than or equal to a designed characteristic impedance of the second microstrip line.

3. The power amplifier of claim 1, wherein a dielectric constant $\varepsilon_{r1}$ of the first PCB is greater than or equal to a dielectric constant $\varepsilon_{r2}$ of the second PCB, and wherein a dielectric thickness $d_1$ of the first PCB is less than a dielectric thickness $d_2$ of the second PCB when the dielectric constant $\varepsilon_{r1}$ of the first PCB is equal to the dielectric constant $\varepsilon_{r2}$ of the second PCB.

4. The power amplifier of any one of claims 1 to 3, wherein a third terminal of the circulator is further connected to a third microstrip line arranged on the first PCB or the second PCB.

5. The power amplifier of claim 4, wherein a designed characteristic impedance of the third microstrip line is equal to a designed characteristic impedance of the second microstrip line.

6. The power amplifier of any one of claims 1 to 3, wherein the power amplification tube circuit includes multiple stages of power amplification tubes arranged on the first PCB, the multiple stages of power amplification tubes are successively cascaded by means of fourth microstrip lines, and the power amplification tube cascaded at the end is connected to the first terminal of the circulator by means of the first microstrip line.

7. The power amplifier of any one of claims 1 to 3, wherein the power amplification tube circuit comprises a power divider, multiple stages of power amplification tubes, and a power combiner, the power divider, the multiple stages of power amplification tubes, and the power combiner being arranged on the first PCB, the multiple stages of power amplification tubes being successively cascaded by means of fourth microstrip lines, and
wherein at least two power amplification tubes are cascaded at the end, input terminals of at least two last-stage power amplification tubes are respectively connected to a fourth microstrip line following the power amplifier tube of a previous stage by means of the power divider, output terminals of the at least two last-stage power amplification tubes are respectively connected to the power combiner, and the power combiner is connected to the first terminal of the circulator by means of the first microstrip line.

8. The power amplifier of any one of claims 1 to 3, wherein a plurality of circulators are provided, second terminals of the plurality of circulators being connected to the second microstrip line by means of a power combiner arranged on the second PCB,

wherein the power amplification tube circuit includes a power divider and multiple stages of power amplification tubes, the power divider and the multiple stages of power amplification tubes being arranged on the first PCB, the multiple stages of power amplification tubes being successively cascaded by means of fourth microstrip lines, and
wherein a plurality of power amplification tubes are cascaded at the end and the same as the circulators in number, input terminals of the plurality of last-stage power amplification tubes are respectively connected to the fourth microstrip line following the power amplifier tube of a previous stage by means of the power divider, and output terminals of the plurality of last-stage power amplification tubes are respectively connected to first terminals of the corresponding circulators by means of the first microstrip line.

9. The power amplifier of claim 1, wherein the first terminal of the circulator is soldered on the first microstrip line, and the second terminal of the circulator is soldered on the second microstrip line.

10. The power amplifier of claim 1, further comprising a radio frequency adapter, the second terminal of the circulator being connected to the radio frequency adapter by means of the second microstrip line.

FIG. 1

FIG. 2

FIG. 3

FIG. 4

## INTERNATIONAL SEARCH REPORT

| International application No. |
|---|
| **PCT/CN2020/139580** |

| **A.** | **CLASSIFICATION OF SUBJECT MATTER** |
|---|---|
| | H03F 3/20(2006.01)i |

According to International Patent Classification (IPC) or to both national classification and IPC

| **B.** | **FIELDS SEARCHED** |
|---|---|

Minimum documentation searched (classification system followed by classification symbols)

H03F

Documentation searched other than minimum documentation to the extent that such documents are included in the fields searched

Electronic data base consulted during the international search (name of data base and, where practicable, search terms used)

CNPAT, WPI, EPODOC, CNKI, IEEE: 放大器, 电路板, 放大电路, 环型器, 微带, 贴片, 功率放大器, 带状线, circulator, 微波传输线, 环行器, PCB板, 功放, 环形器, PA, microstrip, 烧毁, 发热, 散热, 第二, 另一块

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| PX | CN 111030617 A (COMBA TELECOM SYSTEMS (CHINA) CO., LTD.) 17 April 2020 (2020-04-17)<br>　　claims 1-10 | 1-10 |
| X | CN 203632622 U (CHINA GRENTECH CORPORATION LIMITED) 04 June 2014 (2014-06-04)<br>　　description, paragraphs [0022]-[0027] | 1-10 |
| A | CN 206517393 U (BEIJING SEVENSTAR MICROWAVE ELECTRONIC TECHNOLOGY CO., LTD.) 22 September 2017 (2017-09-22)<br>　　entire document | 1-10 |
| A | CN 107846830 A (CHENGDU XINTONG SOFTWARE CO., LTD.) 27 March 2018 (2018-03-27)<br>　　entire document | 1-10 |
| A | CN 201904764 U (BEIJING BBEF SCIENCE & TECHNOLOGY CO., LTD.) 20 July 2011 (2011-07-20)<br>　　entire document | 1-10 |

☐ Further documents are listed in the continuation of Box C.　☑ See patent family annex.

| * Special categories of cited documents: | "T" | later document published after the international filing date or priority date and not in conflict with the application but cited to understand the principle or theory underlying the invention |
|---|---|---|
| "A" document defining the general state of the art which is not considered to be of particular relevance | | |
| "E" earlier application or patent but published on or after the international filing date | "X" | document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" document referring to an oral disclosure, use, exhibition or other means | | |
| "P" document published prior to the international filing date but later than the priority date claimed | "&" | document member of the same patent family |

| Date of the actual completion of the international search | Date of mailing of the international search report |
|---|---|
| **14 March 2021** | **24 March 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/139580**

| Patent document cited in search report | | | Publication date (day/month/year) | Patent family member(s) | Publication date (day/month/year) |
|---|---|---|---|---|---|
| CN | 111030617 | A | 17 April 2020 | None | |
| CN | 203632622 | U | 04 June 2014 | None | |
| CN | 206517393 | U | 22 September 2017 | None | |
| CN | 107846830 | A | 27 March 2018 | None | |
| CN | 201904764 | U | 20 July 2011 | None | |

Form PCT/ISA/210 (patent family annex) (January 2015)